# EUROPEAN PATENT APPLICATION

(11) **EP 2 264 377 A2**
(43) Date of publication of application: **22.12.2010**
(21) Application number: 09290909.2
(22) Date of filing: 04.12.2009
(51) Int. Cl.: F24J 2/54

(54) **Apparatus for two-way tracing and concentrating sunlight of roof installation type**

(30) Priority: 03.06.2009 KR 20090049251
(71) Applicant: Green Plus Co. Ltd., Eungbong-Myeon, Yesan-Gun Chuncheongnam-Do, 340-824 (KR); Park, Young Hwan, Pyeongtaek-Si, Gyeonggi-Do, 459-824 (KR)
(72) Inventor: Park, Young Hwan, Pyeongtaek-Si, Gyeonggi-Do, 459-824 (KR)
(74) Representative: Corret, Hélène

(57) **Abstract**

Disclosed is an apparatus for two-way tracing and condensing sunlight of a roof installation type which traces a direction of sunlight according to variations of an altitude or orbit of the sun to maximize absorbing efficiency, and strengthens a roof fixing structure thereof. The apparatus for two-way tracing and condensing sunlight of the roof installation type includes: a horizontal truss; a roof truss which forms a triangular structure inclined to both sides on the horizontal truss in a plural number, and forms a roof member thereon; an open hinge which is formed on a top end of the roof truss to be extended in a lateral direction, and arranged in a vertical direction in a plural number; a plurality of first solar module plates and second solar module plates which are formed on both inclined surfaces outside the roof truss respectively to absorb sunlight, brought into surface-contact with each other on the left and right sides, and installed to interoperate with each other in a lateral direction, upper portions thereof being pivotably coupled to the open hinges in both directions; and a driving means which supports lower portions of the plurality of first solar module plates and second solar module plates, and pushes or pulls the lower portions thereof so that the plurality of first solar module plates and second solar module plates can pivot individually or together in both left and right directions around the hinges. Therefore, the apparatus traces the direction of sunlight according to variations of the altitude or orbit of the sun and pivots the solar module plate to maximize condensing efficiency, improves environment-friendly energy production efficiency by using the roof area which is a unnecessary space without requiring a large ground area, and provides the structure strong against wind or load by firmly fixing the solar module plate to the roof.

## Description

### [Technical Field]

The present invention relates to an apparatus for condensing sunlight of a roof installation type, and more particularly, to an apparatus for two-way tracing and condensing sunlight of a roof installation type which traces a direction of sunlight according to variations of an altitude or orbit of the sun, pivots a solar module plate to maximize condensing efficiency, and strengthens a roof fixing structure thereof.

### [Background Art]

In general, sunlight generation indicates a generation method for converting sunlight directly into electric power via a solar battery.

As compared with other types of generation, solar energy generation generates clean energy without air pollution, noise, heat generation, vibration, etc., seldom requires fuel transfer and maintenance and management of generation equipment, increases a lifespan of an apparatus, and simplifies decision of an equipment scale and installation works.

A sunlight generation system has advantages in that an energy source is clean and infinite, and the generation system is easily maintained and repaired, can be implemented into a unmanned system and has a long lifespan.

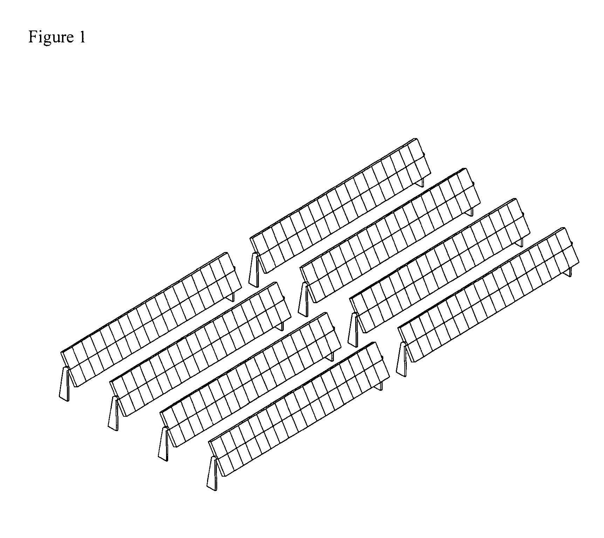

FIG. 1 shows a conventional apparatus for condensing sunlight of a fixed type. The conventional apparatus has the cheapest stable structure, and is mostly used in a comparatively remote region where an installation area is not limited. Particularly, the conventional apparatus is normally installed in an island of a strong wind velocity. The conventional apparatus adopts an array supporting method relatively often used because initial installation costs are small and no difficulty occurs in repair and management. A domestic sunlight system for an island has been standardized as the fixed type system.

In addition, there may be used an apparatus for two-way condensing sunlight of a fixed type, wherein the foregoing fixed type structures are installed in both directions.

However, since the conventional apparatus for condensing sunlight of the fixed type is fixedly installed to face one direction, when sunlight is optimally condensed on one surface, sunlight efficiency is reduced on the other opposite surface. As a result, condensing efficiency of the overall system is lowered according to variations of an altitude or orbit of sunlight.

Moreover, since the conventional apparatus is installed mostly on the ground, an installation place thereof is limitative. When the conventional apparatus is installed on the roof or rooftop, it is weak to wind or load.

### [Disclosure]

### [Technical Problem]

Accordingly, the present invention is conceived to solve the aforementioned problems in the prior art. An object of the present invention is to provide an apparatus for two-way tracing and condensing sunlight of a roof installation type which traces a direction of sunlight according to variations of an altitude or orbit of the sun and pivots a solar module plate so as to maximize condensing efficiency.

In addition, another object of the present invention is to improve environment-friendly energy production efficiency using a roof area which is a unnecessary space without requiring a large ground area by implementing a roof installation type on the roof of a building, and to provide a structure strong against wind or load by firmly fixing a means for fixing and pivoting a solar module plate to the roof.

### [Technical Solution]

According to an aspect of the present invention for achieving the above objects, there is provided an apparatus for two-way tracing and condensing sunlight of a roof installation type, comprising: a horizontal truss which has a structure of a horizontal direction; a roof truss which forms a triangular structure inclined to both sides on the horizontal truss in a plural number, and forms a roof member thereon; an open hinge which is formed on a top end of the roof truss to be extended in a lateral direction, and arranged in a vertical direction in a plural number; a plurality of first solar module plates and second solar module plates which are formed on both inclined surfaces outside the roof truss respectively to condense sunlight, brought into surface-contact with each other on the left and right sides, and installed to interoperate with each other in a lateral direction, upper portions thereof being pivotably coupled to the open hinges in both directions; and a driving means which supports lower portions of the plurality of first solar module plates and second solar module plates, and pushes or pulls the lower portions thereof so that the plurality of first solar module plates and second solar module plates can pivot individually or together in both left and right directions around the hinges.

The plurality of first solar module plates and the plurality of second solar module plates are formed in both directions around the open hinges to face each other, and arranged in a zigzag shape to alternate with each other in terms of plane arrangement.

The driving means includes: a first motor; a first driving pipe which is extended in a lateral direction to rotate with the first motor; a plurality of first rack pinions which are connected to the first driving pipe to convert a rotational motion of the first motor into a linear motion; a plurality of first driven pipes which are coupled to the plurality of first rack pinions to perform a linear motion in the front-rear direction; a plurality of first open push rods which have one sides hinge-coupled to the plurality of first driven pipes side by side to move horizontally, and the other sides hinge-coupled to the lower portions of the plurality of first solar module plates respectively to lift the first solar module plates in the front up-down direction; a second motor; a second driving pipe which is extended in a lateral direction to rotate with the second motor; a plurality of second rack pinions which are connected to the second driving pipe to convert a rotational motion of the second motor into a linear motion; a plurality of second driven pipes which are coupled to the plurality of second rack pinions to perform a linear motion in the front-rear direction; and a plurality of second open push rods which have one sides hinge-coupled to the plurality of second driven pipes side by side to move horizontally, and the other sides hinge-coupled to the lower portions of the plurality of second solar module plates respectively to lift the second solar module plates in the rear up-down direction.

The first open push rod and the second open push rod which are adjacent to each other are alternately formed side by side not to interfere with each other, and connected from the first and second driven pipes to the first and second solar module plates, respectively.

The first open push rod and the second open push rod are formed in the shape of a bracket such that they are connected to four points of the first and second solar module plates and one point of the first and second driven pipes, respectively.

The first and second driven pipes are formed in parallel in a plural number side by side, and alternately arranged one by one.

The roof member has a plurality of through holes formed therein so that the plurality of first open push rods and second open push rods can pass therethrough.

The roof member selectively forms an opaque or transparent panel on a surface of the roof truss.

In addition, preferably, the apparatus further includes a light tracing and driving controller which traces an orbit or altitude of the sun and outputs signals of different sizes according to the traced orbit or altitude of the sun, wherein the driving means pivots the plurality of first solar module plates and second solar module plates in the left-right direction around the hinges according to the sizes of the signals output from the light tracing and driving controller, and changes angles thereof according to sunlight.

According to another aspect of the present invention, there is provided an apparatus for two-way tracing and condensing sunlight of a roof installation type, comprising: a building with a triangular roof; and a plurality of solar module plates which are installed in a plural number in both directions around a hinge formed at a center of a top end of the roof to pivot individually or together in the left-right direction around the hinge and condense sunlight.

Preferably, the apparatus further includes a driving means which is installed below the plurality of solar module plates to pivot the plurality of solar module plates individually or together in the left-right direction around the hinge.

More preferably, the plurality of solar module plates which are formed side by side on any one-side surface in both directions among the plurality of solar module plates interoperate with each other and pivot together in the left-right direction.

### [Advantageous Effects]

According to the present invention, the apparatus for two-way tracing and condensing sunlight of the roof installation type traces the direction of sunlight according to variations of the altitude or orbit of the sun and pivots the solar module plate so as to maximize condensing efficiency.

In addition, the apparatus for two-way tracing and condensing sunlight of the roof installation type improves environment-friendly energy production efficiency using the roof area which is a unnecessary space without requiring a large ground area by implementing the roof installation type on the roof of the building, and provides the structure strong against wind or load by firmly fixing the means for fixing the solar module plate to the roof and pivoting the solar module plate.

### [Description of Drawings]

FIG. 1 is a perspective view illustrating a conventional apparatus for tracing and condensing sunlight of a fixed type;
FIG. 2 is a side view illustrating an apparatus for two-way tracing and condensing sunlight of a roof installation type according to the present invention;
FIG. 3 is a plane view of FIG. 2;
FIG. 4 is a side view illustrating an apparatus for two-way tracing and condensing sunlight according to the present invention, when first and second solar module plates are provided in a plural number;
FIG. 5 is a plane view of FIG. 4; and
FIGS. 6 and 7 are perspective views illustrating an apparatus for two-way tracing and condensing sunlight of a roof installation type according to the present invention.

**[Explanation of Reference Numerals for Major Portions Shown in Drawings]**

| | |
|---|---|
| 100: Light tracing and driving controller | 102: Open hinge |
| 105: Horizontal truss | 110: Gutter beam |
| 115: Roof truss | 114: Pillar |
| 116: Gutter | 118: Auxiliary pillar truss |
| 119: Roof member | 120: Through hole |
| 201: First solar module plate | 203: First open push rod |
| 204: First driven pipe | 206: First rack pinion |
| 207: Pipe roller | 208: First driving pipe |
| 209: First push rod hinge | 212: Rack pinion support beam |
| 213: First motor | 401: Second solar module plate |
| 403: Second open push rod | 404: Second driven pipe |
| 406: Second rack pinion | 407: Pipe roller |
| 408: Second driving pipe | 409: Second push rod hinge |
| 412: Rack pinion support beam | 413: Second motor |

### [Best Mode for Invention]

Hereinafter, exemplary embodiments of the present invention will be described in detail with reference to the accompanying drawings.

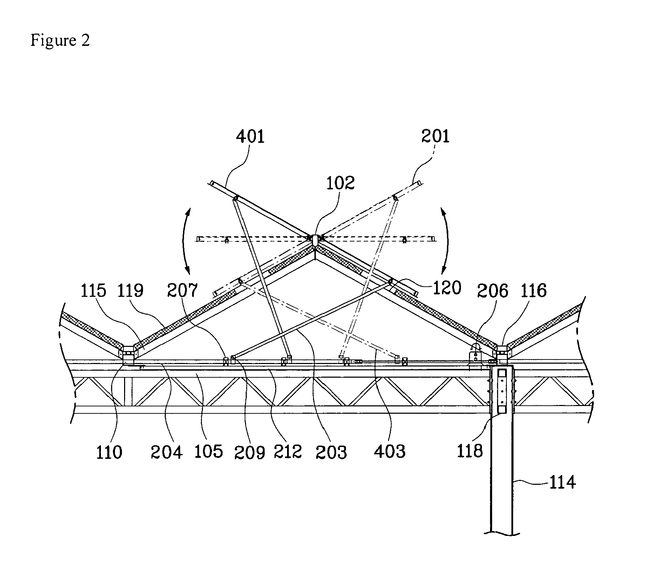

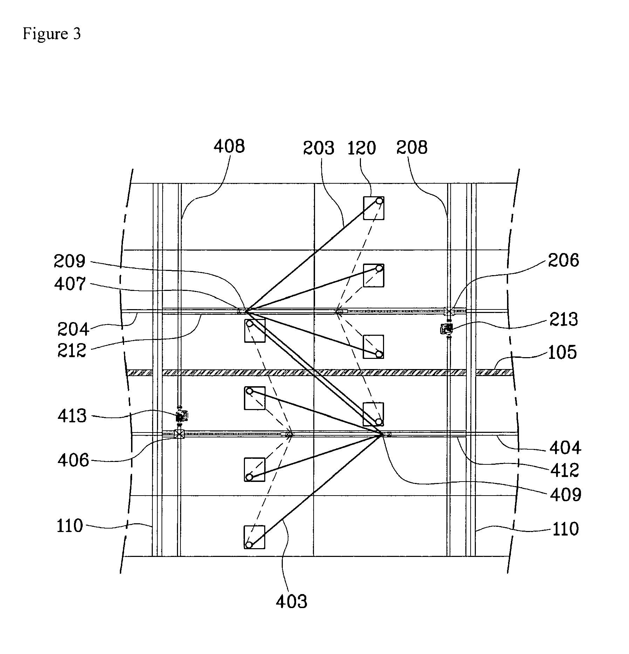

FIG. 2 is a side view illustrating an apparatus for two-way tracing and condensing sunlight of a roof installation type according to the present invention, and FIG. 3 is a plane view of FIG. 2.

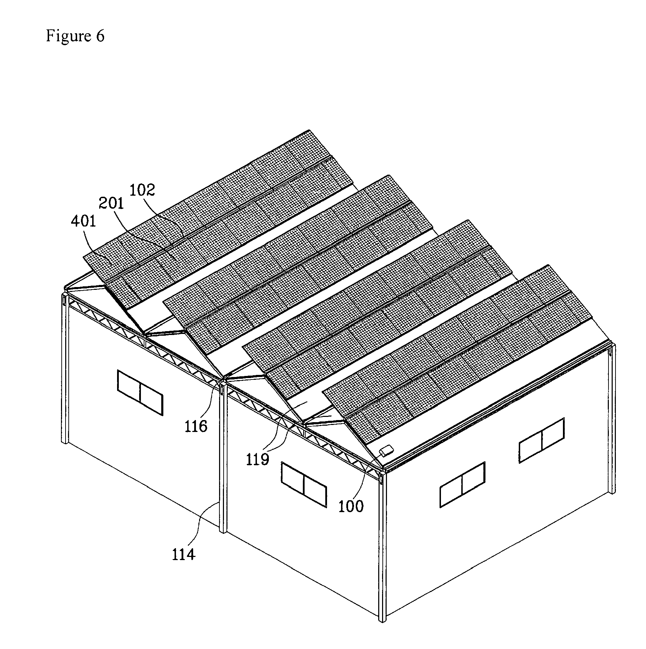

As illustrated in the drawings, the apparatus for two-way tracing and condensing sunlight of the roof installation type according to the present invention includes a light tracing and driving controller (100; refer to FIG. 6), a first solar module plate 201, an open hinge 102, a first open push rod 203, a horizontal truss 105, a gutter beam 110, a pillar 114, a roof truss 115, a gutter 116, an auxiliary pillar truss 118, a roof member 119, a through hole 120, a first driven pipe 204, a first rack pinion 206, a pipe roller 207, a first driving pipe 208, a first push rod hinge 209, a rack pinion support beam 212, a first motor 213, a second solar module plate 401, a second open push rod 403, a second driven pipe 404, a second rack pinion 406, a pipe roller 407, a second driving pipe 408, a second push rod hinge 409, a rack pinion support beam 412, and a second motor 413.

As illustrated in FIG. 6, the light tracing and driving controller 100 described below is installed on the roof member 119 to trace an orbit or altitude of the sun. For example, the light tracing and driving controller 100 is attached with two or more optical sensors (not shown), and traces a point where amounts of light entering the two or more optical sensors are the same, to thereby ensure maximum energy efficiency. Since it can be easily constructed according to the well-known prior art, detailed explanation thereof is omitted.

The horizontal truss 105 has a structure of a horizontal direction. The horizontal truss 105 may be formed on a special pillar 114 or auxiliary pillar 118.

The roof truss 115 forms a triangular roof on the horizontal truss 105. That is, the roof truss 115 forms a triangular structure inclined to both sides on the horizontal truss 105 in a plural number, and forms the roof member 119 thereon.

The horizontal truss 105 and the roof truss 115 constitute a building with a general triangular roof.

In addition, the open hinge 102 is formed on a top end of the roof truss 115 to be extended in a lateral direction, and arranged in a vertical direction in a plural number.

The first solar module plate 201 and the second solar module plate 401 are formed on both inclined surfaces outside the roof truss 115 respectively to condense sunlight, and upper portions thereof are pivotably coupled to the open hinge 102 in both directions. Here, the first solar module plate 201 and the second solar module plate 401 are brought into surface-contact with each other on the left and right sides, and installed in a plural number to interoperate with each other in a lateral direction.

In addition, the driving means of the present invention supports lower portions of the plurality of first solar module plates 201 and second solar module plates 401, and pushes or pulls the lower portions thereof so that the plurality of first solar module plates 201 and second solar module plates 401 can pivot individually or together in both left and right directions around the hinges.

Particularly, the first solar module plates 201 and the second solar module plates 401 preferably pivot from the east to the west according to a traveling direction of the sun.

To this end, the driving means includes the first motor 213, the first driving pipe 208, the plurality of first rack pinions 206, the plurality of first driven pipes 204, the plurality of first open push rods 203, the second motor 413, the second driving pipe 408, the plurality of second rack pinions 406, the plurality of second driven pipes 404, and the plurality of second open push rods 403.

The first driving pipe 208 is extended in a lateral direction to rotate with the first motor 213, and the plurality of first rack pinions 206 are connected to the first driving pipe 208 to convert a rotational motion of the first motor 213 into a linear motion.

The plurality of first driven pipes 204 are coupled to the plurality of first rack pinions 206 to perform a linear motion in the front-rear direction.

The plurality of first open push rods 203 have one sides hinge-coupled to the plurality of first driven pipes 204 side by side to move horizontally, and the other sides hinge-coupled to the lower portions of the plurality of first solar module plates 201 respectively to lift the first solar module plates 201 in the front up-down direction.

To this end, the roof member 119 has a plurality of through holes 120 formed therein so that the plurality of first open push rods 203 and second open push rods 403 can pass therethrough.

Moreover, the first open push rod 203 and the second open push rod 403 are formed in the shape of a bracket such that they are connected to four points of the first and second solar module plates 201 and 401 and one point of the first and second driven pipes 204 and 404, respectively.

The second driving pipe 408 is extended in a lateral direction to rotate with the second motor 413, and the plurality of second rack pinions 406 are connected to the second driving pipe 408 to convert a rotational motion of the second motor 413 into a linear motion.

The plurality of second driven pipes 404 are coupled to the plurality of second rack pinions 404 to perform a linear motion in the front-rear direction.

The plurality of second open push rods 403 have one sides hinge-coupled to the plurality of second driven pipes 404 side by side to move horizontally, and the other sides hinge-coupled to the lower portions of the plurality of second solar module plates 401 respectively to lift the second solar module plates 401 in the rear up-down direction.

Here, the first motor 213 and the second motor 413, which produce a rotational force, may be provided with a reduction gear (not shown) for example, or implemented into worm geared motors including a built-in reduction gear. Preferably, the first motor 213 and the second motor 413 may rotate normally and reversely according to a size of a signal output from the light tracing and driving controller 100 discussed later.

As described above, the first solar module plate 201 condenses sunlight in a state where the upper portion thereof is pivotably hinge-fixed to the top end of the roof truss 115, and one side of the first open push rod 203 supports the lower portion of the first solar module plate 201. Further, the first pivoting means 200 fixes the other side of the first open push rod 203, and pushes or pulls the first open push rod 203 to pivot the first solar module plate 201 according to the orbit or altitude of the sun traced by the light tracing and driving controller 100.

Accordingly, when the first motor 213 rotates, the first driven pipe 204 moves in the front-rear direction. As the first driven pipe 204 moves in the front-rear direction, the first open push rod 203 pushes or pulls the lower portion of the first solar module plate 201 to change an angle of the first solar module plate 201. As a result, the first solar module plate 201 can always maintain an optimum angle to condense sunlight according to the orbit or altitude of the sun traced by the light tracing and driving controller 100.

Meanwhile, the second solar module plate 401 condenses sunlight in a state where the upper portion thereof is pivotably hinge-fixed to the top end of the roof truss 115, and is formed in the opposite side to the first solar module plate 201.

One side of the second open push rod 403 supports the lower portion of the second solar module plate 401. Furthermore, the second pivoting means 400 fixes the other side of the second open push rod 403, and pushes or pulls the second open push rod 403 to pivot the second solar module plate 401 according to the orbit or altitude of the sun traced by the light tracing and driving controller 100.

Here, the first solar module plate 201 and the second solar module plate 401 are preferably installed in the east-west direction. Therefore, the first solar module plate 201 and the second solar module plate 401 are pivoted according to a traveling orbit or altitude of the sun, thereby condensing sunlight in optimum state.

Accordingly, the apparatus of the present invention can condense sunlight through the first solar module plate 201 and the second solar module plate 401, always maintaining an optimum angle according to the orbit or altitude of the sun traced by the light tracing and driving controller 100.

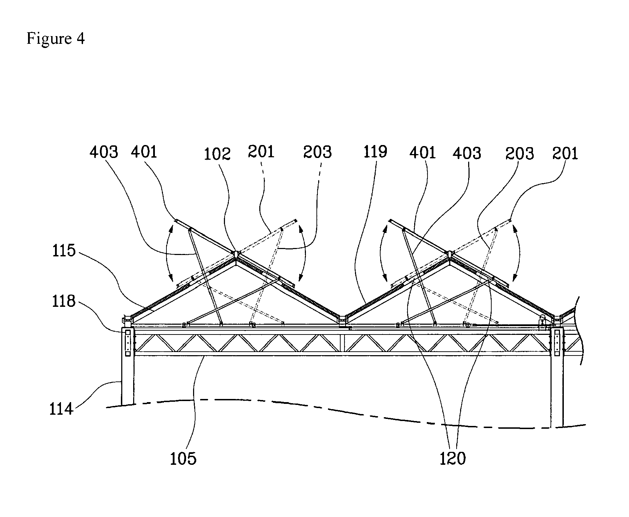

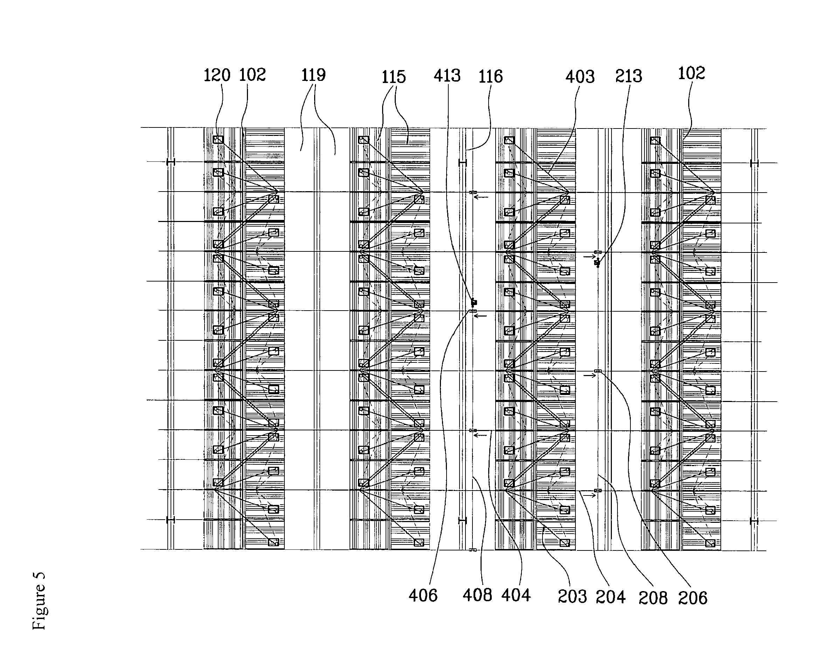

FIG. 4 is a side view illustrating an apparatus for two-way tracing and condensing sunlight according to the present invention, when first and second solar module plates are provided in a plural number, and FIG. 5 is a plane view of FIG. 4.

As illustrated in the drawings, the apparatus for two-way tracing and condensing sunlight of the roof installation type according to the present invention includes a first solar module plate 201, an open hinge 102, a first open push rod 203, a horizontal truss 105, a gutter beam 110, a pillar 114, a roof truss 115, a gutter 116, an auxiliary pillar truss 118, a roof member 119, a through hole 120, a first driven pipe 204, a first rack pinion 206, a pipe roller 207, a first driving pipe 208, a first push rod hinge 209, a rack pinion support beam 212, a first motor 213, a second solar module plate 401, a second open push rod 403, a second driven pipe 404, a second rack pinion 406, a pipe roller 407, a second driving pipe 408, a second push rod hinge 409, a rack pinion support beam 412, and a second motor 413.

As shown in the drawings, the first driving pipe 208 is extended in a lateral direction to rotate with the first motor 213, and the plurality of first rack pinions 206 are connected to the first driving pipe 208 to convert a rotational motion of the first motor 213 into a linear motion. In addition, the plurality of first driven pipes 204 are coupled to the plurality of first rack pinions 206 to perform a linear motion in the front-rear direction, and the plurality of first open push rods 203 have one sides hinge-coupled to the plurality of first driven pipes 204 side by side to move horizontally, and the other sides hinge-coupled to lower portions of the plurality of first solar module plates 201 respectively to lift the first solar module plates 201 in the front up-down direction.

In this construction, when the first motor 213 rotates, the first driving pipe 208 rotates in the same direction, so that the plurality of first rack pinions 206 and the plurality of first driven pipes 204 coupled thereto move in the front-rear direction. Moreover, as the plurality of first driven pipes 204 move in the front-rear direction, the first open push rods 203 push or pull the lower portions of the plurality of first solar module plates 201, to thereby batch-control angles of the plurality of first solar module plates 201.

Further, the plurality of second open push rods 403 and the plurality of second solar module plates 401 corresponding thereto are formed on the second driven pipe 404 in a vertical direction. Furthermore, the second driving pipe 408 which rotates with the second motor 413 is further provided, and the plurality of second rack pinions 406 and the plurality of second driven pipes 404 corresponding thereto are formed on the second driving pipe 408 in a horizontal direction.

Accordingly, when the second motor 413 rotates, the second driving pipe 408 rotates in the same direction, so that the plurality of second rack pinions 406 and the plurality of second driven pipes 404 coupled thereto move in the front-rear direction. Thus, the second open push rods 403 push or pull the lower portions of the plurality of second solar module plates 401, to thereby batch-control angles of the plurality of second solar module plates 401.

Here, as described above, preferably, the first open push rod 203 and the second open push rod 403 which are adjacent to each other and support the first solar module plate 201 and the second solar module plate 401 are alternately formed not to interfere with each other, and connected to the first and second solar module plates 201 and 401 and the first and second driven pipes 204 and 404, respectively.

In addition, the first and second driven pipes 204 and 404 are formed in parallel in a plural number side by side, and alternately arranged one by one.

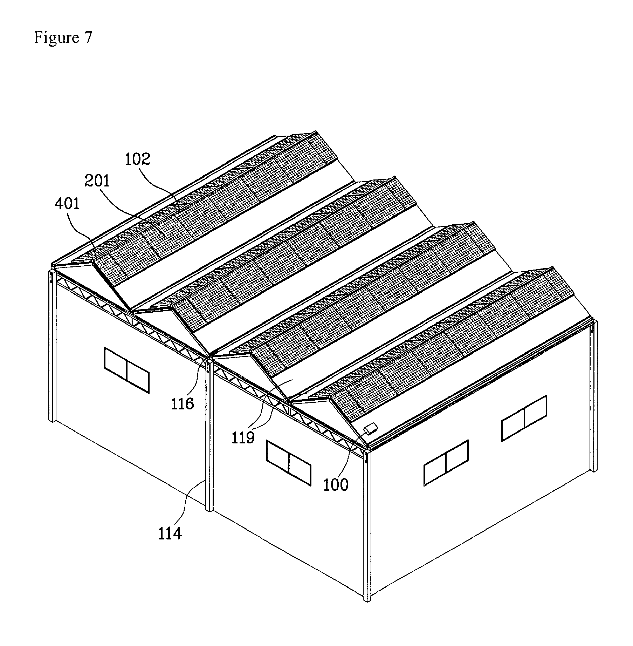

FIGS. 6 and 7 are perspective views illustrating an apparatus for two-way tracing and condensing sunlight of a roof installation type according to the present invention.

As illustrated in the drawings, preferably, a plurality of first solar module plates 201 and a plurality of second solar module plates 401 are formed in both directions around open hinges 102 to face each other, and arranged in a zigzag shape to alternate with each other in terms of plane arrangement.

Moreover, as set forth herein, a light tracing and driving controller 100 of the present invention can trace an orbit or altitude of the sun and output signals of different sizes according to the traced orbit or altitude of the sun.

Therefore, a driving means 200 pivots the plurality of first solar module plates 201 and second solar module plates 401 in the left-right direction around the hinges according to the sizes of the signals output from the light tracing and driving controller 100, and changes angles thereof according to sunlight.

A roof member 119 may selectively form an opaque or transparent panel on a surface of a roof truss 115.

As shown in the drawings, according to the present invention, in order to condense optimum sunlight, the second solar module plate 401 preferably moves in the opposite way to the first solar module plate 201.

That is, when the apparatus of the present invention is not used like the nighttime, as illustrated in FIG. 7, the plurality of first solar module plates 201 and second solar module plates 401 are folded down.

Then, if sunlight arises, the light tracing and driving controller 100 traces an orbit or altitude of the sun, and outputs signals of different sizes according to the traced orbit or altitude of the sun, and the driving means 200 pivots the plurality of first solar module plates 201 and second solar module plates 401 in the left-right direction around the hinges according to the sizes of the signals output from the light tracing and driving controller 100, and changes the angles thereof according to sunlight.

Here, when the second solar module plate 401 is pivoted to be located on the upper side, the first solar module plate 201 is located on the lower side, and conversely, when the second solar module plate 401 is pivoted to be located on the lower side, the first solar module plate 201 is located on the upper side, so that the two solar module plates 201 and 401 are arranged toward the sun (refer to FIG. 6).

The conventional apparatus for condensing sunlight of the fixed type has a disadvantage in that, when sunlight is condensed on one surface in optimum state, sunlight efficiency is lowered on the other opposite surface. However, according to the present invention, since the two solar module plates 201 and 401 always follow the sun, it is possible to condense sunlight in optimum state.

### [Industrial Applicability]

As a result, according to the present invention, the apparatus for two-way tracing and condensing sunlight of the roof installation type traces the position of sunlight according to variations of the altitude or orbit of the sun and pivots the solar module plate so as to maximize condensing efficiency. Also, the apparatus for two-way tracing and condensing sunlight of the roof installation type can improve environment-friendly energy production efficiency using the roof area which is a unnecessary space without requiring a large ground area by implementing the roof installation type on the roof of the building, and can provide the structure strong against wind or load by firmly fixing the means for fixing and pivoting the solar module plate to the frame.

The scope of the present invention is not limited to the embodiment described and illustrated above but is defined by the appended claims. It will be apparent that those skilled in the art can make various modifications and changes thereto within the scope of the invention defined by the claims. Therefore, the true scope of the present invention should be defined by the technical spirit of the appended claims.

## Claims

1. An apparatus for two-way tracing and condensing sunlight of a roof installation type, comprising:
a horizontal truss which has a structure of a horizontal direction;
a roof truss which forms a triangular structure inclined to both sides on the horizontal truss in a plural number, and forms a roof member thereon;
an open hinge which is formed on a top end of the roof truss to be extended in a lateral direction, and arranged in a vertical direction in a plural number;
a plurality of first solar module plates and second solar module plates which are formed on both inclined surfaces outside the roof truss respectively to condense sunlight, brought into surface-contact with each other on the left and right sides, and installed to interoperate with each other in a lateral direction, upper portions thereof being pivotably coupled to the open hinges in both directions; and
a driving means which supports lower portions of the plurality of first solar module plates and second solar module plates, and pushes or pulls the lower portions thereof so that the plurality of first solar module plates and second solar module plates can pivot individually or together in both left and right directions around the hinges.

2. The apparatus as claimed in claim 1, wherein the plurality of first solar module plates and the plurality of second solar module plates are formed in both directions around the open hinges to face each other, and arranged in a zigzag shape to alternate with each other in terms of plane arrangement.

3. The apparatus as claimed in claim 1, wherein the driving means comprises:
a first motor;
a first driving pipe which is extended in a lateral direction to rotate with the first motor;
a plurality of first rack pinions which are connected to the first driving pipe to convert a rotational motion of the first motor into a linear motion;
a plurality of first driven pipes which are coupled to the plurality of first rack pinions to perform a linear motion in the front-rear direction;
a plurality of first open push rods which have one sides hinge-coupled to the plurality of first driven pipes side by side to move horizontally, and the other sides hinge-coupled to the lower portions of the plurality of first solar module plates respectively to lift the first solar module plates in the front up-down direction;
a second motor;
a second driving pipe which is extended in a lateral direction to rotate with the second motor;
a plurality of second rack pinions which are connected to the second driving pipe to convert a rotational motion of the second motor into a linear motion;
a plurality of second driven pipes which are coupled to the plurality of second rack pinions to perform a linear motion in the front-rear direction; and
a plurality of second open push rods which have one sides hinge-coupled to the plurality of second driven pipes side by side to move horizontally, and the other sides hinge-coupled to the lower portions of the plurality of second solar module plates respectively to lift the second solar module plates in the rear up-down direction.

4. The apparatus as claimed in claim 3, wherein the first open push rod and the second open push rod which are adjacent to each other are alternately formed side by side not to interfere with each other, and connected from the first and second driven pipes to the first and second solar module plates, respectively.

5. The apparatus as claimed in claim 3, wherein the first open push rod and the second open push rod are formed in the shape of a bracket such that they are connected to four points of the first and second solar module plates and one point of the first and second driven pipes, respectively.

6. The apparatus as claimed in claim 3, wherein the first and second driven pipes are formed in parallel in a plural number side by side, and alternately arranged one by one.

7. The apparatus as claimed in claim 3, wherein the roof member has a plurality of through holes formed therein so that the plurality of first open push rods and second open push rods can pass therethrough.

8. The apparatus as claimed in claim 7, wherein the plurality of through holes formed in the roof member are formed in sizes corresponding to sizes of the plurality of first and second solar module plates, and opened and closed according to pivoting of the plurality of first and second solar module plates to circulate the outdoor air to the indoor side.

9. The apparatus as claimed in claim 1, wherein the roof member selectively forms an opaque or transparent panel on a surface of the roof truss.

10. The apparatus as claimed in claim 1, further comprising a light tracing and driving controller which traces an orbit or altitude of the sun and outputs signals of different sizes according to the traced orbit or altitude of the sun,
wherein the driving means pivots the plurality of first solar module plates and second solar module plates in the left-right direction according to the sizes of the signals output from the light tracing and driving controller, and changes angles thereof according to sunlight.

11. An apparatus for two-way tracing and condensing sunlight of a roof installation type, comprising:
a building with a triangular roof; and
a plurality of solar module plates which are installed in a plural number in both directions around a hinge formed at a center of a top end of the roof to pivot in the left-right direction individually or together and condense sunlight.

12. The apparatus as claimed in claim 11, further comprising a driving means which is installed below the plurality of solar module plates to pivot the plurality of solar module plates individually or together in the left-right direction around the hinge.

13. The apparatus as claimed in claim 11, wherein the plurality of solar module plates which are formed side by side on any one-side surface in both directions among the plurality of solar module plates interoperate with each other and pivot together in the left-right direction.
